# EUROPEAN PATENT APPLICATION

(11) **EP 1 616 926 A1**
(43) Date of publication of application: **18.01.2006**
(21) Application number: 05447071.1
(22) Date of filing: 31.03.2005
(51) Int. Cl.: C09G 1/02, H01L 21/321

(54) **Slurry composition and method for chemical polishing of copper integrated with tungsten based barrier metals**

(30) Priority: 15.07.2004 US 588247
(71) Applicant: INTERUNIVERSITAIR MICROELEKTRONICA CENTRUM ( IMEC), 3001 Leuven (BE)
(72) Inventor: Ernur, Didem, 3001 Leuven (BE); Terzieva, Valentina, 3060 Bertem (BE); Schuhmacher, Jörg, 1390 Grez Doiceau (BE)
(74) Representative: Van Malderen, Joelle

(57) **Abstract**

The present invention is related to a slurry composition for polishing copper integrated with tungsten containing barrier layers and its use in a CMP method.

The present invention is also related to a method for polishing copper integrated with tungsten containing barrier layers by means of an aqueous solution containing abrasive particles, an inorganic acid such as HNO₃ as etchant for copper that prevents galvanic corrosion of the tungsten containing metal barrier and at least one organic compound to provide sufficient copper corrosion inhibition.

## Description

### Field of the invention

The present invention is related to the field of semiconductor processing. More specifically it is related to the chemical mechanical polishing (CMP) process of copper integrated with tungsten based barrier layer.

More specifically it concerns a new slurry composition and a method to polish copper and subsequently the tungsten containing barrier layer while avoiding galvanic corrosion of tungsten and simultaneously providing sufficient copper removal without copper corrosion.

### Background of the invention

Copper (Cu) is selected as the interconnect material of choice for the fabrication of ultra large scale integrated circuits (ULSI) due to its lower resistivity and high electro - migration resistance as compared to aluminum (Al). This requires the utilization of the damascene process for the fabrication of Cu interconnects. Unlike Al metallization, damascene process relies on depositing Cu onto the patterned dielectric by electrochemical deposition (ECD). Since Cu readily diffuses into the dielectric, a diffusion barrier is deposited prior to Cu deposition.

Along with the decrease in feature sizes and the limitation of the physical vapor deposition process (PVD) for generations below 0.13 mm technology, the demand for effective diffusion barriers with decreasing film thickness has increased. This has necessitated the use of atomic layer deposition (ALD) for barrier metal deposition. This is because ALD provides deposition of a uniform thin layer

In the manufacturing of microelectronic devices Cu is susceptible to corrosion for many reasons. Even though Cu is a noble metal it readily reacts in oxidizing environments. Corrosion of Cu interconnects during IC manufacturing is stated to occur mostly during the CMP process where Cu contacts the CMP slurry.

Chemical mechanical planarization or polishing (CMP) is used to polish excess Cu overburden and barrier metal to provide surface planarity.

Chemical corrosion, photo-corrosion, narrow trench corrosion and galvanic corrosion are reported to be the possible mechanisms of Cu corrosion during CMP. Galvanic or in other words bimetallic corrosion occurs due to the electrochemical incompatibility between two dissimilar metals that are in electrical and ionic contact. Thus if the barrier metal is electrochemically incompatible with Cu then galvanic corrosion takes place during the CMP process where slurry acts as the electrolyte. It is either Cu or barrier metal that acts as the anode and suffers from enhanced etching as a result of the galvanic coupling.

Many barrier metals such as Ta, TaN, Ti, TiN, W, Tungsten Nitride Carbide (WNC) have been the scope of research for their potential use as diffusion barriers due to their ease of deposition, good step coverage, good adhesion between Cu and the dielectric.

However, some are reported to be responsible for galvanic corrosion. Tungsten containing barriers, e.g. WNC, suffer from galvanic corrosion when H₂O₂ containing slurries are used. This means that there will be loss of barrier material on the top corners of the trenches at the interface of the copper and barrier layer after polishing.

Indeed, tungsten (W) etching during CMP is attributed to the oxidation and subsequently dissolution of the W-oxide complex into the slurry leading to the formation of a complex surface film.

The oxidation occurs in two steps in many cases. H₂O₂ is shown to form a complicated non-stoichiometric WO₂/WO₃ duplex oxide, which is stated to be more soluble in the presence of H₂O₂ than in its absence.

The introduction of very thin barrier layers (such as ALD deposited WNC barriers) make this problem even more critical.

It is believed that the mechanism of chemical etching of ALD (Atomic Layer Deposition) WNC barrier metal is also due to the oxidation of W in the WNC film by H₂O₂ in the solution. The oxidation and subsequently dissolution of W from the W containing barrier layer is strongly enhanced because of the galvanic coupling of the W containing barrier to the Cu layer which gives rise to high potential difference between the W layer and the Cu layer.

Therefore, the successful integration of W containing barriers layers, such as WCN, in the copper metallization scheme requires the use of another oxidizer in the slurry.

It is therefore the object of the invention to solve the shortcomings of the commercial available polishing slurries and to provide a slurry composition, which makes it possible to polish Cu structures with integrated W containing barriers while avoiding galvanic corrosion. The integration of thin W containing barrier layers in Cu damascene structures is thus possible.

### Summary of the invention

The present invention provides a new slurry (aqueous) composition to chemical mechanical polish copper integrated with tungsten (W) containing barrier layers such that unwanted galvanic corrosion leading to dissolution of tungsten is avoided.

The present invention provides a new slurry composition for polishing of copper integrated with a W containing barrier layer comprising HNO₃ and at least one corrosion inhibitor of copper.

The present invention provides a new slurry composition comprising HNO₃ combined with at least one organic compound, wherein said organic compound is preferably at least one sugar compound and/or at least one organic acid.

Another object of the present invention also relates to the use of a composition of the invention for preventing or reducing the galvanic corrosion of Cu and/or W containing barrier.

The present invention also provides a method for polishing Cu structures and its integrated W containing barrier layer, and avoiding (or reducing) galvanic corrosion of Cu and/or of the barrier, using a slurry composition of the invention.

The present invention provides a method for chemical mechanical polishing of copper integrated with tungsten (W) containing barrier layers comprising the step of contacting (or polishing) said layers with a slurry composition comprising HNO₃ and at least one sugar compound and/or at least one organic acid.

Also provided is a polishing method comprising the following steps of:
- substantially removing the overburden of copper by means of a H₂O₂ containing slurry composition,
- removing the remaining copper overburden by means of a slurry composition comprising HNO₃ combined with at least one sugar compound and/or at least one organic acid.

Said second step of removing the remaining overburden of copper is performed by means of a slurry composition according to the invention.

Said sugar compound(s) in a composition of the invention is preferably a monosaccharide, or a mixture of monosaccharides, such as fructose, galactose and/or glucose.

The sugar compound can also be an amino-sugar compound and/or a sugar-alcohol compound.

The sugar compound can also be a pyranoside.

In a composition according to the invention, said sugar compound(s) concentration is preferably comprised between (about) 0.5 wt % and (about) 15 wt %, based on the total weight of the composition.

In a composition of the invention comprising galactose, the galactose concentration is preferably of about 1 wt%, based on the total weight of the composition.

In a composition of the invention comprising fructose, the fructose concentration is preferably of about 10 wt%, based on the total weight of the composition.

Said organic acid compound in a composition of the invention can be a monocarboxylic acid or a polycarboxylic acid. Preferably the organic acid is citric acid or acetic acid, and even more preferably malic acid.

Said organic acid compound can also be derived from a sugar compound, which can also be referred to herein as "sugar" acids. Preferred examples of these "sugar" acids are "aldonic" acid (such as gluconic acid), "alduronic" acid(such as glucuronic acid), and "aldaric" acid (such as glucaric acid), which are derived from glucose. These acids exhibit an increased corrosion inhibition towards copper. For that reason these sugar derivatives are even more preferred organic acid compounds.

In a composition according to the invention, said organic acid compound(s) concentration is preferably comprised between about 0.0001 wt % and about 0.5 wt % based on the total weight of the composition.

In a composition comprising oxidized sugar compound(s), the concentration of said oxidized sugar compound(s) is preferably comprised between about 0.0001 wt % and about 0.5 wt %, based on the total weight of the composition.

In a composition according to the invention, HNO₃ is preferably in a concentration comprised between about 1.5 and about 5.0 wt %, based on the total weight of the composition.

A preferred composition of the invention comprises HNO₃ in a concentration comprised between about 1.5 and about 5.0 wt % and at least one sugar compound, preferably at least one monosaccharide, in a concentration comprised between about 0.5 wt % and about 15 wt %, based on the total weight of the composition.

A more preferred composition of the invention comprises HNO₃ in a concentration comprised between about 1.5 and about 5.0 wt % and at least one oxidized sugar compound in a concentration comprised between (about) 0.0001 wt % and (about) 0.5 wt %, based on the total weight of the composition.

### Brief description of the drawings

All drawings are intended to illustrate some aspects and embodiments of the present invention. Not all alternatives and options are shown and therefore the invention is not limited to the content of the given drawings.

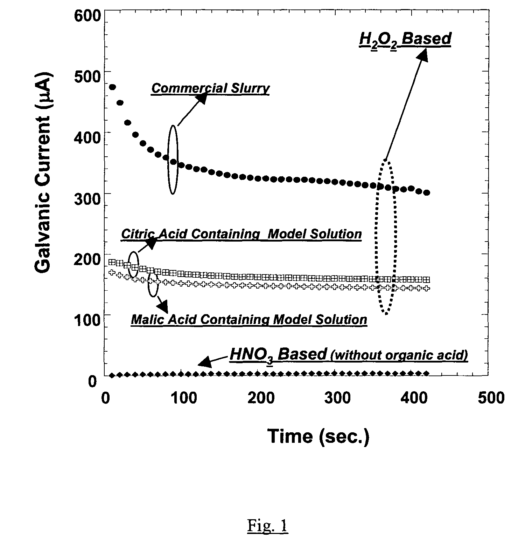

Figure 1 shows the galvanic current change as a function of dip time for Cu-WNC galvanic couple. Higher galvanic current values are observed by the H₂O₂ based slurry (commercially available slurry). The figure also shows that an HNO₃ based solution has the lowest galvanic current value. Malic acid and citric acid contained in a 9 vol% H₂O₂ solution still show high galvanic current values.

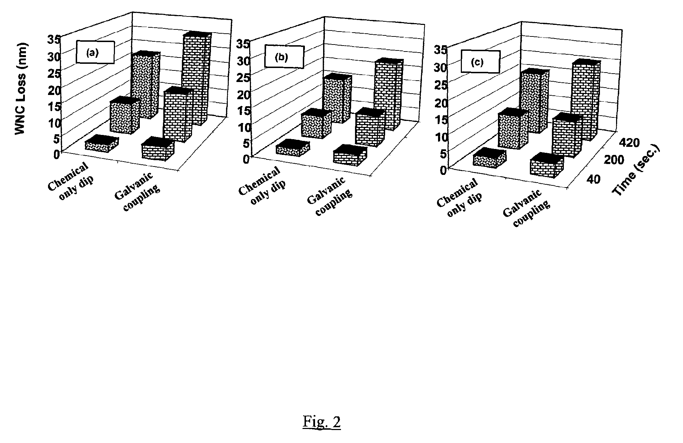

Figure 2 shows a comparison of WNC etch rate between chemical only dip and galvanic coupling to Cu by using an H₂O₂ based commercial slurry (a), a citric acid solution containing 9 vol% H₂O₂ (b) and a malic acid solution containing 9 vol% H₂O₂ (c). It is shown that galvanic coupling gives rise to higher etch rate values for all solutions. However, a commercial available H₂O₂ based slurry reveals higher etch rates compared to the H₂O₂ solution containing citric acid or malic acid.

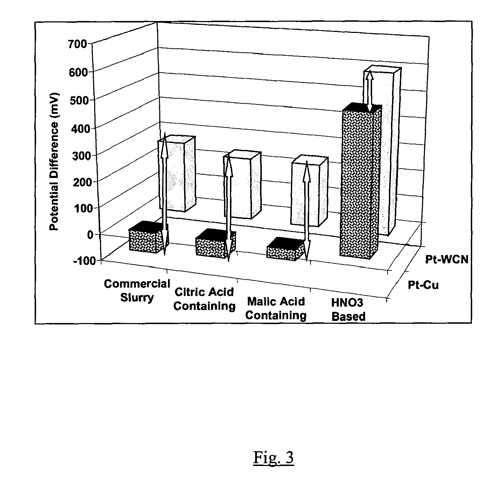

Figure 3 shows the potential difference against reference Pt electrode for Cu and WNC in different solutions. The larger the difference between Pt-Cu and Pt-WNC, the more likely it is that WNC and Cu will suffer from galvanic corrosion when they are brought together in such solutions. The solutions tested here are an H₂O₂ based commercial slurry, a citric acid solution containing 9 vol% H₂O₂, a malic acid solution containing 9 vol% H₂O₂ and an HNO₃ based solution. In this respect, HNO₃ based solution gives the lowest potential difference.

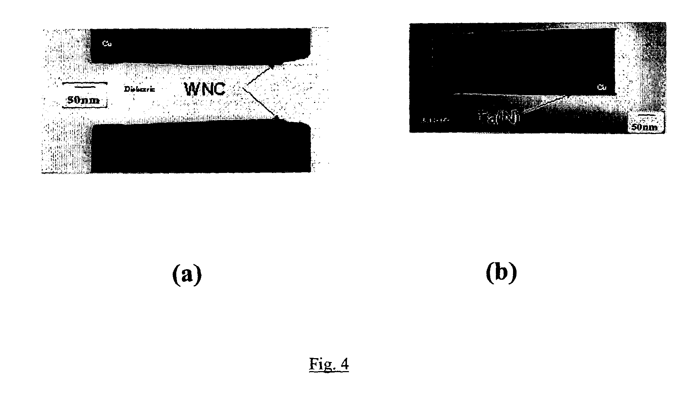

Figure 4 shows TEM images of (a) Cu damascene structures with a WNC barrier layer and (b) Cu damascene structure(s) with a TaN barrier layer, both structures are polished by using a polishing slurry with peroxide (here H₂O₂) as etchant. There is loss of WNC on the top corners of the trenches at the interface between WNC and Cu and no Ta loss is observed after polishing with H₂O₂, which means that there is no galvanic corrosion effect in the Cu structure with Ta(N) containing barriers.

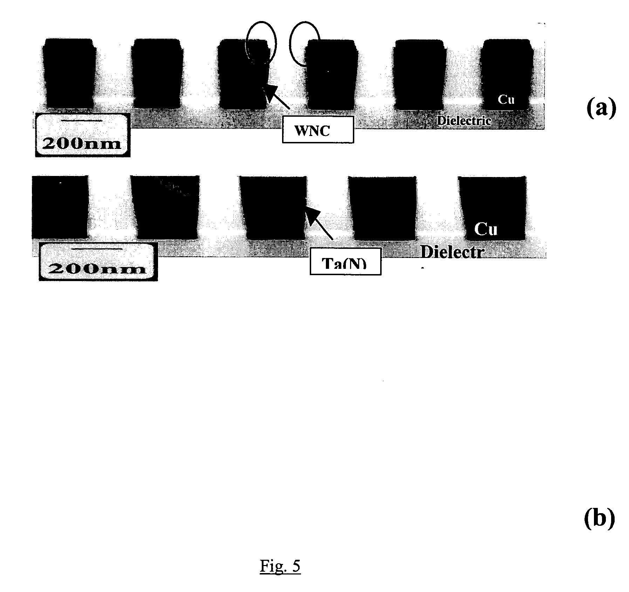

Figure 5 shows TEM images of (a) Cu damascene structures with a WNC barrier layer and (b) Cu damascene structures with a Ta(N) barrier layer, both structures are polished by using a polishing slurry with H₂O₂ as etchant. There is loss of WNC on the top corners of the trenches at the interface between WNC and Cu but there is no Ta loss observed after polishing with H₂O₂, which means that there is no galvanic corrosion effect in the Cu structure with Ta(N) containing barriers.

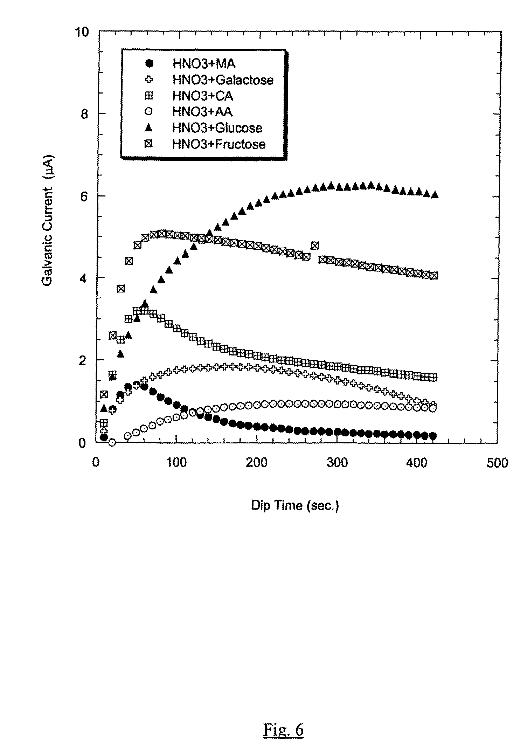

Figure 6 shows galvanic current as a function of time by galvanic coupling of Cu-WNC using a slurry composition of the present invention comprising HNO₃ and in addition, respectively, Malic Acid (MA), Galactose, Citric Acid (CA), Acetic Acid (AA), Glucose, or Fructose.

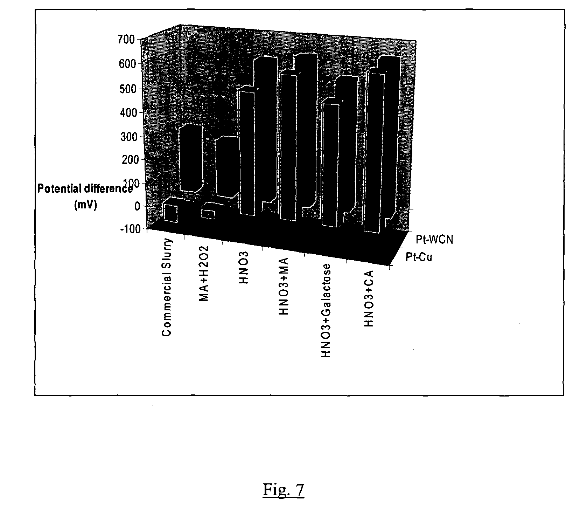

Figure 7 shows potential difference against a Pt electrode by using different slurry compositions.

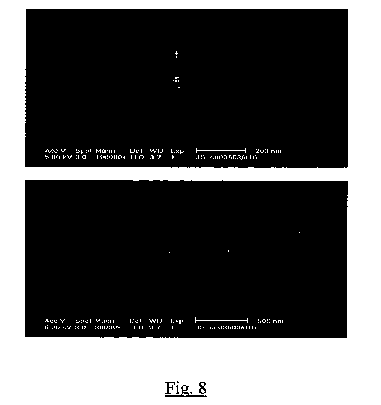

Figure 8 shows cross section SEM images after polishing Cu structures with integrated WNC barrier layers using an HNO₃ based slurry with malic acid in an 0.2 µm isolated copper line and in 0.2 µm semi dense lines.

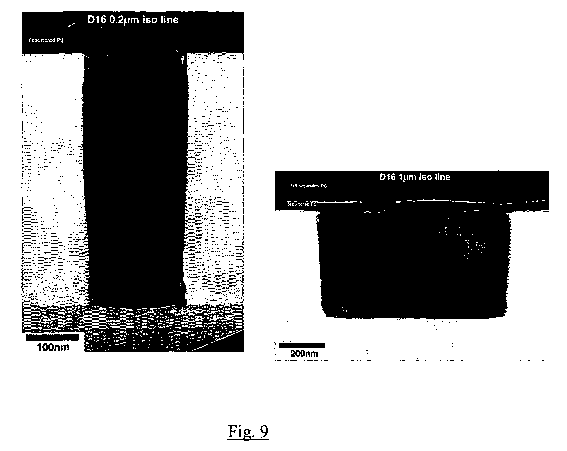

Figure 9 shows cross section TEM images after polishing using a HNO₃ based slurry with malic acid in an 0.2 µm isolated copper line (left side) and in a 1.0 µm isolated copper line (right side)

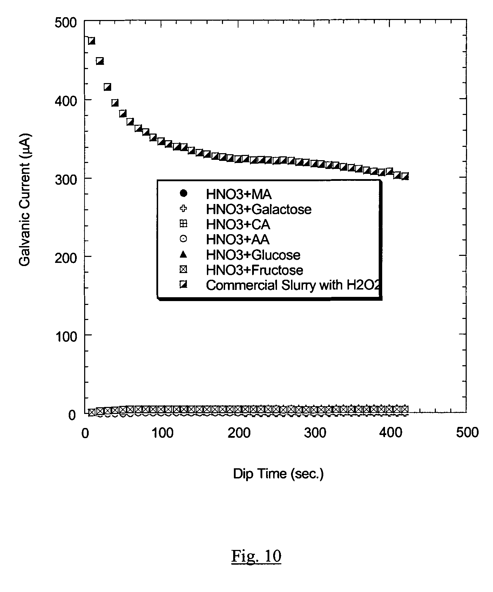

Figure 10 shows current change as a function of time obtained after chemical dip of Cu/WNC structures in commercial available slurries containing H₂O₂ and in HNO₃ based solutions with additions of an organic compound to inhibit copper corrosion (organic acids or monosaccharides).

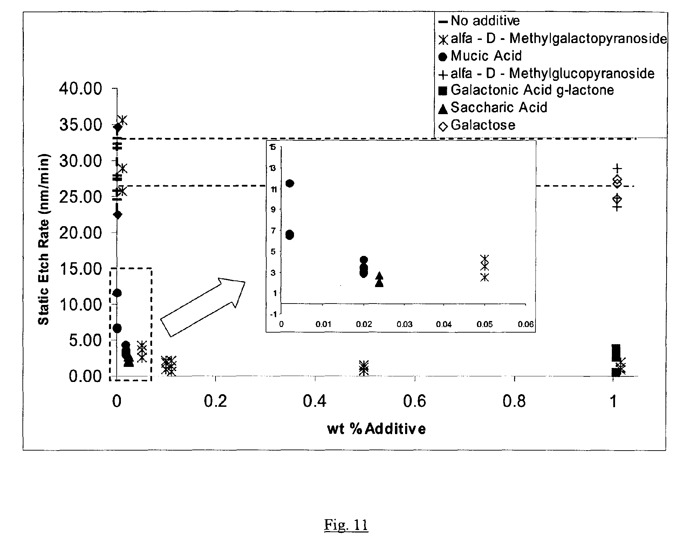

Figure 11 shows static etch rate values of copper for solutions containing different sugar compounds. It is clear that derivatives from sugars such as saccharic acid (also known as glucaric acid) and mucic acid (also known as D-Galactaric acid) are more effective in decreasing the static etching of copper and thus exhibit higher corrosion inhibition characteristics.

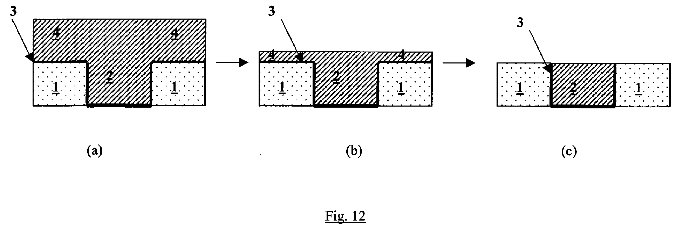

Figures 12 (a) to 12 (c) illustrate the two-step polishing method (CMP) of the present invention. Figure 12 (a) shows the Cu damascene structure before polishing (CMP) with Cu overburden. Figure 12 (b) illustrates the resulting structure after the first polishing step using an H₂O₂ containing slurry and removing more than 3/4 of the Cu overburden (preferably removing about 90% and/or leaving about 100 nm of Cu overburden). Figure 12 (c) illustrates the resulting structure after the second polishing step using an HNO₃ based slurry composition of the invention for removing the remaining overburden of Cu and WCN barrier.

### Description of the invention

In relation to the drawings, the present invention is described in detail in the sequel.

In the context of the present invention, the term "(polishing) slurry composition" means that abrasive particles are present in the aqueous composition of the invention. Said abrasive particles are for example metal oxide particles such as colloidal silica (SiO₂), alumina (Al₂O₃) particles, or any other known abrasive particles.

A slurry (aqueous) composition in accordance with the present invention comprises HNO₃ and at least one corrosion inhibitor for copper and optionally any additive(s) to enhance the polishing of copper.

A slurry composition in accordance with the present invention comprises HNO₃ and at least one organic compound acting as corrosion inhibitor. Said organic compound(s) is (are) preferably at least one sugar compound and/or at least one organic acid.

Said HNO₃ acts as an oxidizing compound for Cu and gives no rise to galvanic corrosion when used to polish Cu structures with integrated W containing barrier layers.

Said HNO₃ replaces the oxidizer usually used, H₂O₂. Therefore, a composition comprising HNO₃ and at least one sugar compound and/or at least one organic acid, with no H₂O₂, is also contemplated.

Said sugars or organic acids act as corrosion inhibitors for copper.

Preferred concentrations used for HNO₃ in combination with organic acids are between (about) 1.5 and (about) 5.0 wt %, based on the total weight of the composition. More preferably, HNO₃ concentration in combination with organic acids is (about) 3 wt %, based on the total weight of the composition.

The preferred concentration ranges for the organic acid(s) are between (about) 0.0001 wt % and (about) 0.5 wt %. More preferably, the organic acid(s) concentration is (about) 0.05 wt %, based on the total weight of the composition.

An organic acid in a composition of the invention contains at least one carboxylic acid group.

Experiments performed with Malic Acid, which has 2 carboxylic groups and 4 carbon chain length, with Citric Acid, which has 3 carboxylic groups and 5 carbon chain length, or with Acetic Acid, which has 1 carboxylic group and 1 carbon chain length, show no effect on galvanic current (Figures 6 and 10).

Indeed, as shown in Figures 6 and 10, the galvanic current is below 3 µA for all the tested compositions of the invention, including the compositions comprising the organic acids.

This low galvanic current (few µA) is negligible compared to the galvanic current values obtained with H₂O₂ based slurries (more than 300 µA).

These low values indicate that said compositions comprising the organic acids do not give rise to galvanic corrosion of the W containing barrier.

Some other preferred acids include polycarboxylic acids, such as those of the formula HOOC- (CR₁R₂) ₙ-COOH, wherein R₁ or R₂ is selected from the group consisting of hydrogen, alkyl, substituted alkyl, hydroxyl, ether, ester, etc., and wherein n is an integer from 1 to 20, e.g. HOOC-CH₂-CH(OH)-COOH.

Any mono-, di-, tri-, and poly-carboxylic acids can be used. A composition of the invention can comprise a mixture of two, three or more of said organic acids.

In a preferred composition of the invention, said organic acid(s) is (are) "sugar acid(s)", i.e. carboxylic acids derived from sugar compounds. Examples of these carboxylic acids derived from sugar compounds are aldaric, alduronic, and aldonic acids derived from an aldosugar (or aldose) compound. For example glucaric acid (an aldaric acid), gluconic acid (an aldonic acid) and glucuronic acid (an alduronic acid) are carboxylic acids derived from glucose.

The acids derived from sugars (more particularly from monosaccharides) have high corrosion inhibition effects and are more particularly preferred compounds for a composition of the invention.

Indeed, lower concentration of these "sugar acids" can be used to achieve the same corrosion inhibition compared to the sugar compound itself from which they derive. These acids show a very high inhibition efficiency.

Preferred concentration ranges for HNO₃ when combined with "sugar acids" are between (about) 1.5 and (about) 5 wt% based on the total weight of the composition. More preferably, HNO₃ concentration when combined with "sugar acids" is (about) 3 wt % based on the total weight of the composition.

The preferred concentration ranges for "sugar acids" are between (about) 0.0001 wt % and (about) 0.5 wt % based on the total weight of the composition. More preferably, the "sugar acid(s)" concentration is (about) 0.05 wt % based on the total weight of the composition.

In a preferred composition of the invention, said sugar is a monosaccharide.

Preferred monosaccharides include tetroses such as erythrose and threose; pentoses such as ribose, arabinose, xylose, lyxose; hexoses such as allose, altrose, glucose, mannose, gluose, idose, galactose, talose; and heptoses such as sedoheptulose.

Said monosaccharides can be in ring or chain form, and in any isomeric form, such as the D isomer, the L isomer, or mixtures thereof.

Also suitable are amino-sugars or amino-saccharides, such as glucosamine. Other possible derivatives from sugars are the pyranosides: example Methyl pyranoside.

A slurry composition of the invention can comprise a mixture of two, three or more of any of said sugars and/or sugar derivatives.

Preferred concentration ranges for said HNO₃ when combined with any of said sugars and/or sugar derivatives are between (about) 0.1 and (about) 3 wt%, more preferably between (about) 0.5 and (about) 1 wt %, based on the weight of the composition. And more preferably, said HNO₃ concentration is (about) 0.75 wt %.

Preferred concentration ranges for said HNO₃ when combined with galactose and/or fructose are between (about) 0.1 and (about) 3 wt%, more preferably between (about) 0.5 and (about) 1 wt %, based on the weight of the composition. And more preferably, said HNO₃ concentration is (about) 0.75 wt %.

Concerning sugar and/or sugar derivatives, preferred concentrations are in the range of (about) 0.5 wt % to (about) 15 wt % sugar in solution, based on the weight of the composition.

In a preferred composition of the invention comprising galactose and/or fructose, the galactose concentration is (about) 1 wt% and/or the fructose concentration is (about) 10 wt% based on the total weight of the composition.

In figure 6 galvanic current values are shown using HNO₃ based slurries with fructose, glucose and galactose additions. The very low galvanic current values do not give rise to galvanic corrosion of the W containing barrier.

The amount of sugar compound added to the solution is dependent on the result to be achieved, and corresponds to a compromise between achieving acceptable removal rate and acceptable corrosion inhibition.

A composition of the invention can comprise a mixture of two, three or more of said sugars and/or organic acids.

Beside said organic compounds, other compounds can be added to a composition of the invention to enhance the polishing process. An example of such an organic component is an alcohol, e.g. methanol. Experiments carried out with small additions of methanol (0.1 wt %) to a solution containing HNO₃ and galactose showed increased inhibition efficiency due to the presence of methanol.

A composition of the present invention can be used in a chemical mechanical polishing process (CMP) for copper and WNC layers removal.

According to the present invention, a method for chemical mechanical polishing of copper integrated with tungsten (W) containing barrier layers comprises the step of contacting said layers (both Cu and subsequently W containing layers) with a slurry composition of the invention comprising HNO₃ and at least one sugar compound and/or at least one organic acid.

In a preferred method of the invention, the W containing barrier layer to be polished is a thin WNC barrier layer deposited by Atomic Layer Deposition. This thin barrier layer is deposited within semiconductor structures such as trenches before the deposition of copper to avoid diffusion of the copper in to the insulator layer.

Said WNC layers preferably have a thickness of (about) 1 to (about) 20 nm and more preferably of (about) 5 nm. Said layers are very thin compared to the thickness of e.g. currently used Ta(N) barriers deposited by Physical Vapor Deposition (PVD) and having a thickness of 20 to 200 nm.

A composition according to the invention used to perform the polishing has a polishing or removal rate towards copper of (about) 30 nm copper removed per minute.

This is a rather slow polishing rate compared to the polishing rate of approximately 350 nm copper per minute obtained with commercial available slurries containing H₂O₂.

In order to obtain higher throughput values needed in real processing of semiconductor substrates, and still avoid the galvanic corrosion of the W containing layer, a sequential polishing method of the invention is disclosed.

Figure 12 illustrates the different steps of this polishing (CMP) method. Figure 12 (a) shows a Cu damascene structure (comprising a copper structure **2** with a barrier layer **3** (e.g. WCN) in a dielectric material **1)** before polishing (CMP) the Cu and WCN overburden. Figure 12 (b) illustrates the resulting structure after the first polishing step using an H₂O₂ containing slurry and removing more than 3/4 of the Cu overburden **4.** Figure 12 (c) illustrates the resulting structure after the second polishing step using the HNO₃ based slurry of the present invention removing the remaining overburden of Cu **4** and WCN barrier **3.**

The two step polishing method can comprise the steps of (as shown in Figure 12 (a) to 12 (c)):
- substantially removing the copper overburden **4** by means of a H₂O₂ containing slurry composition, and then
- removing the remaining overburden of copper **4** and WCN barrier layer **3** by means of a slurry composition of the invention comprising at least one sugar compound and/or at least one organic acid in addition of HNO₃.

With this two steps method of the invention, a satisfactory Cu removal rate is obtained in the first step and W dissolution within the structure due to galvanic corrosion is avoided by a second polishing step using a slurry composition according to the invention.

The term "substantially" used in a method of the invention refers to the removal, in the first polishing step, of more than 50%, preferably more than 75% (or %), more preferably more than 80%, 85% or 90% (and less than 100%) of the total amount of copper overburden **4.** Even more preferably, about 90% to about 95% of the total amount of copper overburden **4** is removed.

As an example if the copper overburden to be removed is 1 µm, the amount of copper overburden removed in the first step is preferably more than 750 nm (up to (about) 1 nm) and more preferably about 900 nm.

In the second polishing step, the remaining copper overburden and the remaining W containing barrier overburden (e.g. WNC, generally in the order of 5 nm) are removed.

In a method of the invention, in a first polishing step, the excess amount of copper to be polished is performed with a slurry having a high efficiency and removal rate towards copper. These slurries contain H₂O₂ as oxidizing compound and are commercially available.

The thickness of the layer to be removed in this first polishing step is preferably between (about) 500 nm and (about) 1000 nm, depending on technology node.

Special care needs to be taken that the polishing is stopped before the W containing barrier is reached. A copper layer of preferably less than (about) 100 nm and more preferably between (about) 1 nm and (about) 75 nm thickness can be remained on the W containing barrier after the first polishing step to protect the W containing barrier (e.g. WNC layer) from galvanic corrosion by H₂O₂.

In a method of the invention, in a second and much slower polishing step performed with a slurry composition according to the present invention, the remaining copper overburden and remaining W barrier overburden (e.g. WNC layer underneath the Cu overburden) are removed.

The second polishing step prevents galvanic corrosion of the barrier and makes integration of W containing barrier in semiconductor processing possible.

Beside the prevention of galvanic corrosion, a slurry composition and a method of the present invention have the advantage of avoiding the extemporaneous addition of chemically unstable oxidizers such as peroxide (more specifically H₂O₂) and peroxo compounds to the slurry, which is time consuming and can cause contamination problems. Indeed, the peroxide (H₂O₂) cannot be added in the slurry long before use because of its short lifetime in the slurry.

### EXAMPLES

### Example 1: galvanic current experiments.

2x7 cm² Cu and WNC (deposited on a blanket Si-wafer) samples are used with 2x2 cm² area of exposure. Cu is deposited by electrochemical plating (ECP) with an underlying 150 nm Cu seed layer. A 60 nm thick WNC is deposited by ALD on 500 nm thick SiO₂. The Cu and WCN samples were electrically contacted to each other through a digital multimeter and dipped respectively in:
- a H₂O₂ based slurry,
- a malic acid contained in a 9 vol. % H₂O₂ solution, and
- a citric acid contained in a 9 vol. % H₂O₂ solution
- a nitric acid based slurry (without further additions).

In solutions containing H₂O₂, H₂O₂ is added just prior to experimentation to suppress the decomposition of H₂O₂.

The galvanic current is measured simultaneously by using a Keithley 195 A digital multimeter that is connected to the galvanic couple Cu/WCN. The results are summarized in figure 1, which shows the galvanic current change as a function of dip time for Cu-WNC galvanic couple.

The higher galvanic current values are obtained by the commercial slurry (H₂O₂ based solution) and the lowest current values are obtained with an HNO₃ based solution (without further addition of an organic compound)).

H₂O₂ based solutions containing respectively additions of citric acid and malic acid also show high galvanic current values.

The initial instability in current is attributed to the initial condition of the surface.

It can be inferred that an HNO₃ based solution prevents the galvanic corrosion of the WNC barrier layer.

### Example 2: WCN loss by chemical dip and galvanic coupling.

The WNC loss is measured after a Cu/WNC galvanic couple (as described in example 1) is contacted (by dipping in the solution) respectively to:
- a H₂O₂ based slurry,
- a malic acid contained in a 9 vol. % H₂O₂ solution, and
- a citric acid contained in a 9 vol. % H₂O₂ solution.

In parallel, the WNC barrier layer sample is dipped in the same three solutions (referred to as chemical only dip), and the WNC loss is also measured in function of time.

The results are summarized in Figure 2, which highlights the comparison between the WNC etch rate in the framework of chemical dip and the WNC etch rate in the framework of galvanic coupling to Cu, for each of the solutions mentioned.

It is shown that galvanic coupling gives rise to higher etch rate values for the three solutions. However, commercial slurry reveals higher etch rates compared to the H₂O₂ based solutions containing citric acid or malic acid.

The addition of organic acids to the H₂O₂ solution could not however avoid galvanic coupling.

In comparison, the WNC etch rate, both after chemical only dip and galvanic coupling to Cu, in a slurry composition of the invention comprising nitric acid (HNO₃) and acetic acid, turned out to be lower than 1 nm/min, in other words, the WNC loss is less than 7 nm after 420 seconds.

### Example 3: Galvanic Etching experiments.

Cu and WNC samples were prepared and used as respectively positive and negative electrodes which were connected through a digital multimeter to measure voltage variation during galvanic coupling experiments. During these experiments the Cu and WNC "electrodes" were contacted respectively with:
- a H₂O₂ based slurry,
- a malic acid contained in a 9 vol. % H₂O₂ solution,
- a citric acid contained in a 9 vol. % H₂O₂ solution,
- a HNO₃ based solution.

Figure 3 summarizes the results obtained; showing the potential difference against reference Pt electrode for Cu and WNC for each solution. The larger the difference is between Pt-Cu and Pt-WNC, the more likely it is that WNC and Cu will suffer from galvanic corrosion when they are brought together in such solutions.

Indeed, the enhancement in etching because of galvanic coupling to Cu arises from the high potential difference between WNC and Cu in these solutions (figure 2).

In this respect, HNO₃ based solution gives the lowest potential difference (figure 3). This is in agreement with the WNC etch rate value by HNO₃ based solution, which is around 1 nm/min.

Looking at Figures 1 and 3, citric acid containing solution result in lower current change compared to the commercial slurry. This shows that WNC is subject to more anodic oxidation by the commercial slurry, thus resulting in more loss of W after galvanic coupling to Cu.

In parallel, the same measurements are done using:
- a commercial slurry (H₂O₂ based solution),
- a 9 vol. % H₂O₂ based solution to which malic acid (e.g. 0.05 wt %) was added,
- a HNO₃ based solution (with no H₂O₂),
- a slurry composition of the invention comprising HNO₃ (e.g. 3 wt %) and citric acid (e.g. 0.05 wt %),
- a slurry composition of the invention comprising HNO₃ (e.g. 3 wt % and malic acid (e.g. 0.05 wt %),
- a slurry composition of the invention comprising HNO₃ (e.g. 0.75 wt %) and fructose (e.g. 10 wt. %).

The results are summarized in Figure 7. There are very little potential differences between the W containing barrier and Cu in the slurry compositions of the invention in comparison with the potential differences observed with the other slurry solutions tested (H₂O₂ based).

Moreover, the potential differences observed with the slurry compositions of the invention are such that no galvanic corrosion is likely to occur.

### Example 4: polishing experiments.

Different Cu damascene structures with either a WNC barrier layer or a Ta(N) barrier layer are polished using different polishing slurries and TEM (Transmission Electron Microscopy) or SEM (Scanning Electron Microscopy) images are taken in order to observe the effect of the different polishing slurries used.

The first Cu damascene structure tested has a WNC barrier layer and is polished with a H₂O₂ based solution (Hitachi slurry C430-A18). The result is shown on Figure 4 (a). A loss of WNC can be noticed on the top corners of the trenches at the interface between WNC and Cu.

Another Cu damascene structure with a Ta(N) barrier layer is polished with a H₂O₂ based solution (Hitachi slurry C430-A18). The result is shown on figure 4 (b). No loss of Ta(N) can be noticed after polishing, which means that there is no galvanic corrosion effect in the Cu structure with Ta(N) containing barrier.

Different Cu damascene structures with a WNC barrier layer are polished on a polishing tool (Megapol) with a slurry composition of the invention comprising HNO₃ and malic acid. Said slurry composition also comprises silica particles.

The results are shown on Figure 8, representing cross section SEM images, and on Figure 9 representing cross section TEM images. No loss of WNC can be noticed after polishing, which means that there is no galvanic corrosion effect generated by a slurry composition of the invention comprising HNO₃ and malic acid, in the Cu structure with WNC containing barrier.

### Example 5: galvanic current experiments.

Cu and WNC samples as described in example 1 are used with 2x2 cm² area of exposure. The Cu and WCN samples were electrically contacted to each other through a digital multimeter and dipped respectively in:
- a H₂O₂ based solution,
- a slurry composition of the invention comprising HNO₃ (e.g. 3 wt %) (and no H₂O₂),
- a slurry composition of the invention comprising HNO₃ (e.g. 3 wt %) and citric acid (e.g. 0.05 wt %),
- a slurry composition of the invention comprising HNO₃ (e.g. 3 wt %) and malic acid (e.g. 0.05 wt %),
- a slurry composition of the invention comprising HNO₃ (e.g. 0.75 wt %) and fructose (e.g. 10 wt %),
- a slurry composition of the invention comprising HNO₃ (e.g. 0.75 wt %)and galactose (e.g. 1 wt %),
- a slurry composition of the invention comprising HNO₃ (e.g. 0.75 wt %)and glucose (e.g. 0.05 wt %).

The results are summarized in figure 6 and figure 10, which show the galvanic current change as a function of time for Cu-WNC galvanic couple.

The higher galvanic current values are obtained with a H₂O₂ based slurry solution (figure 10).

The current values obtained with a composition of the invention correspond to a very little current flow. This means that there is little potential difference built up between the W containing barrier and Cu in said compositions of the invention such that no galvanic corrosion is likely to occur.

This is confirmed by the results represented on Figure 7: the potential difference appears to be high for H₂O₂ based solution in comparison with the potential differences measured with HNO₃ based solutions, in particular with a slurry composition comprising HNO₃ and malic acid or with a slurry composition comprising HNO₃ and galactose.

## Claims

1. A slurry composition for polishing of copper integrated with a W containing barrier layer, said composition comprising HNO₃ and at least one sugar compound and/or at least one organic acid.

2. A composition according to claim 1 wherein at least one sugar compound is a monosaccharide or a mixture of monosaccharides.

3. A composition according to claim 2 wherein said monosaccharide is selected from the group consisting of fructose, galactose and glucose.

4. A composition according to any of claims 1 to 3 wherein said at least one organic acid comprises one, two, three or more carboxylic acid groups.

5. A composition according to claim 4 wherein said at least one organic acid is selected from the group consisting of acetic acid, malic acid, citric acid.

6. A composition according to any of claims 1 to 5 wherein at least one organic acid is an oxidized sugar compound.

7. A composition according to claim 6 wherein said oxidized sugar compound is selected from the group consisting of aldaric, alduronic and aldonic acids.

8. A composition according to any of claims 1 to 7 wherein said sugar compound(s) concentration is comprised between about 0.5 wt % and about 15 wt % based on the total weight of the composition.

9. A composition according to any of claims 3 to 8 wherein said galactose is in a concentration of about 1 wt% based on the total weight of the composition.

10. A composition according to any of claims 3 to 9 wherein said fructose is in a concentration of about 10 wt% based on the total weight of the composition.

11. A composition according to any of claims 1 to 10 wherein said organic acid compound(s) concentration is comprised between about 0.0001 wt % and about 0.5 wt % based on the total weight of the composition.

12. A composition according to any of claims 6 to 11 wherein said oxidized sugar compound(s) concentration is comprised between about 0.0001 wt % and about 0.5 wt based on the total weight of the composition.

13. A composition according to any of claims 1 to 12 wherein HNO₃ is in a concentration comprised between about 1.5 and about 5.0 wt % based on the total weight of the composition.

14. A composition according to any of claims 1 to 13 wherein HNO₃ concentration is comprised between about 1.5 and about 5.0 wt % and said sugar compound(s) concentration is comprised between about 0.5 wt % and about 15 wt % based on the total weight of the composition.

15. Use of a slurry composition according to any of claims 1 to 14 for polishing (a) copper damascene structure(s) with an integrated W containing barrier layer.

16. Use of a slurry composition according to any of claims 1 to 14 for reducing or preventing galvanic corrosion of copper and/or tungsten containing barrier layer.

17. A method for polishing (a) copper damascene structure(s) with an integrated W containing barrier layer comprising the steps of:
- substantially removing the overburden of copper by means of a H₂O₂ containing slurry composition,
- removing the remaining overburden of copper by means of a slurry composition comprising HNO₃ combined with at least one sugar compound and/or at least one organic acid.
